# EUROPÄISCHE PATENTANMELDUNG

(11) **EP 1 050 965 A2**
(43) Veröffentlichungstag der Anmeldung: **08.11.2000**
(21) Anmeldenummer: 00109365.7
(22) Anmeldetag: 02.05.2000
(51) Int. Cl.: H03K 17/082, H03K 17/64, H03K 17/042

(54) **Elektrische Schaltung zum Steuern einer Last**

(30) Priorität: 03.05.1999 DE 19920307
(71) Anmelder: STMicroelectronics GmbH, 85630 Grasbrunn (DE)
(72) Erfinder: Schwartz, Reiner, 85567 Grafing (DE)
(74) Vertreter: Hirsch, Peter

(57) **Zusammenfassung**

In einer Steuer- oder Regelschaltung für eine Last wird ein Sollsignal (Vref) mit einem dem Zustand der Last entsprechenden Istsignal (V_{M}) verglichen, und abhängig von dem Vergleichsergebnis wird in einer Stellsignal-Erzeugungsschaltung (10) ein PWM-Stellsignal (PWM) erzeugt. Das Stellsignal öffnet und schließt einen mit der Last gekoppelten Stromschalter. Zur Bildung des PWM-Stellsignals wird der Inhalt eines Rampenzählers (24) mit dem Inhalt eines Auf/Ab-Zählers (23) von einem Digitalvergleicher (25) verglichen. Um bei starken Abweichungen zwischen Sollsignal und Istsignal eine rasche Annäherung der beiden Signale zu erreichen, wird bei starken Regelabweichungen der Inhalt des Auf/Ab-Zählers (23) relativ schnell gezählt im Vergleich zu geringen Regelabweichungen. Zu diesem Zweck wird der Auf/Ab-Zähler (23) mit einem Taktsignal (CLK_{VCO}) veränderlicher Frequenz betrieben, das von einem spannungsgesteuerten Oszillator (VCO) (28) in Abhängigkeit der Differenz zwischen Sollsignal und Istsignal erzeugt wird.

## Beschreibung

Die Erfindung betrifft eine elektrische Schaltung zum Steuern einer Last nach Maßgabe eines Sollsignals.

Der Begriff "Last" ist hier in weitestem Umfang zu verstehen. In erster Linie handelt es sich um eine elektrische Last, zum Beispiel einen elektrischen Motor, eine Spule, einen Widerstand oder dergleichen, wobei an solche elektrischen Bauelemente dann die eigentliche "Last" gekoppelt sein kann, zum Beispiel in Form eines elektromagnetischen Ventils, einer elektrischen Heizung oder eines mechanisch von einem Elektromotor zu bewegenden Teils.

Um die Erfindung anschaulich darzustellen, soll im folgenden speziell eine induktive Last in Form einer elektromagnetischen Treibervorrichtung für ein Bremsventil einer Bremsanlage betrachtet werden. Bei einer solchen elektromagnetischen Treibervorrichtung geht es um das Steuern/Regeln des Drucks einer Bremsflüssigkeit. Der Druck wird von dem elektromagnetischen Ventil in Abhängigkeit des durch die Spule des Elektromagneten fließenden Stroms eingestellt. Das Stellsignal wird bei einer solchen Steuerung/Regelung üblicherweise einem elektronischen Schalter in Form eines PWM-Stellsignals zugeführt (PWM = Pulse Width Modulation; Pulsbreitenmodulation), wobei dieses PWM-Stellsignal den elektronischen Schalter mit einem bestimmten Tastverhältnis (Verhältnis von Impulsdauer zu Impulspause) öffnet und schließt, so daß der Stromsfluß durch den elektronischen Schalter, welcher in Reihe zu der Last geschaltet ist, den Stromfluß durch die Last festlegt.

Wie bei anderen üblichen Regelschaltungen, ist auch bei der erfindungsgemäßen Schaltung eine erste Signalquelle, die das Sollsignal ausgibt, sowie eine zweite Signalquelle, die ein Istsignal ausgibt, über eine Stellsignal-Erzeugungsschaltung mit einem Stellelement verbunden, zum Beispiel mit dem Steueranschluß eines elektronischen Schalters (zum Beispiel eines MOSFETs).

Im Stand der Technik gibt es eine umfangreiche Menge möglicher Ausgestaltungen für die Stellsignal-Erzeugungsschaltung. Maßgeblich für das Ausgangssignal der Stellsignal-Erzeugungsschaltung ist die Abweichung zwischen Istsignal und Sollsignal. Bei geringer Regelabweichung, also geringer Differenz zwischen Istsignal und Sollsignal, ist das Stellsignal so beschaffen, daß nur noch eine relativ geringe Änderung der zu steuerenden oder zu regelnden Größe in der Last in Richtung des Sollwerts erfolgt. Bei großer Regelabweichung ist das Stellsignal "größer", das heißt, es erfolgt eine raschere Änderung des Istsignals zwecks Annäherung an das Sollsignal.

Um bei starken Regelabweichungen die Annäherung von Sollsignal und Istsignal zu beschleunigen, wird das Stellsignal mit einer Differential-Komponente versehen. Hierdurch wird das Stellsignal bei großer Regelabweichung überproportional verstärkt, um eine möglichst rasche Annäherung des Istwerts an den Sollwert zu erreichen.

Aus dem Stand der Technik sind verschiedenste Maßnahmen bekannt, um neben einer Proportional-Regelung alternativ oder zusätzlich eine Differential- und/oder Integral-Regelung zu erreichen.

In den vergangenen Jahren sind zum Steuern/Regeln elektrischer Lasten mehr und mehr digitale Schaltungen eingesetzt worden. Bei einer digitalen Steuerschaltung wird zur Erzeugung eines PWM-Stellsignals zum Beispiel ein Auf/Ab-Zähler verwendet, dessen sich laufend ändernder Zählerstand mit einem digitalen, periodischen Rampensignal verglichen wird. Je nach Verhältnis der miteinander verglichenen Zahlenwerte ist der Pegel des daraus gebildeten PWM-Stellsignals hoch oder niedrig. Der Auf/Ab-Zähler wird von einem konstanten Taktsignal getaktet, wobei die Zählrichtung abhängig von dem Verhältnis zwischen Sollsignal und Istsignal eingestellt wird.

Man kann nun daran denken, den Zählerstand nicht direkt mit dem Rampensignal zu vergleichen, sondern den Zählerstand des Zählers zunächst umzusetzen gemäß einer vorbestimmten Funktion, um auf diese Weise zum Beispiel ein Proportional-, Integral- oder Differentialverhalten zu erreichen.

Der Erfindung liegt die Aufgabe zugrunde, eine elektrische Schaltung zum Steuern einer Last nach Maßgabe eines Sollsignals anzugeben, bei der mit einfachen Mitteln eine relativ schnelle Annäherung des Istsignals in der Last an das Sollsignal erreicht wird, wobei die Geschwindigkeit der Annäherung zwischen Istsignal und Sollsignal umso stärker ausfällt, je größer die Abweichung ist.

Um diese Aufgabe zu lösen, schlägt die Erfindung eine elektrische Schaltung zum Steuern einer Last nach Maßgabe eines Sollsignals vor, welche umfaßt:
- eine erste Signalquelle, die das Sollsignal ausgibt;
- eine zweite Signalquelle, die ein Istsignal ausgibt, welches repräsentativ ist für den aktuellen Zustand der Last;
- ein Stellelement, das mit der Last gekoppelt ist, und das einen Steueranschluß aufweist, und
- eine Stellsignal-Erzeugungsschaltung, die an einem Eingang ein Abweichungssignal empfängt, welches repräsentativ ist für die Differenz zwischen dem Sollsignal und dem Istsignal, die abhängig von dem Abweichungssignal ein Stellsignal erzeugt, und das Stellsignal über einen Ausgang dem Steueranschluß des Stellelements zuführt,
- wobei die Stellsignal-Erzeugungsschaltung einen Zähler beinhaltet, der in Abhängigkeit von dem Abweichungssignal betrieben wird, um das Stellsignal zu erzeugen, und wobei ein Zähltakteingang des Zählers mit dem Ausgang eines spannungsgesteuerten Oszillators verbunden ist, der an seinem Eingang das Abweichungssignal empfängt.

Anstatt den Zähler mit einem Taktsignal fester Frequenz oder mit einem Taktsignal einer von einer festen Frequenz abgeleiteten Frequenz zu betreiben, wird erfindungsgemäß der Zähler mit dem von dem Ausgang eines spannungsgesteuerten Oszillators abgeleiteten Taktsignal betrieben.

Spannungsgesteuerte Oszillatoren sind im Stand der Technik in verschiedenen Ausführungsformen bekannt. Üblicherweise hängt die Schwingungsfrequenz am Ausgang des spannungsgesteuerten Oszillators (VCO) von der Spannungsdifferenz an seinem Eingangsklemmenpaar ab. Ist die Spannungsdifferenz groß, ist die Ausgangsfrequenz relativ hoch, bei kleiner Spannungsdifferenz ist die Ausgangsfrequenz relativ niedrig.

Die vorliegende Erfindung macht Gebrauch von dieser Besonderheit eines spannungsgesteuerten Oszillators in Verbindung mit einer Steuer- oder Regeleinrichtung. Wenn die Abweichung zwischen Sollsignal und Istsignal groß ist, liefert der spannungsgesteuerte Oszillator am Ausgang ein Signal mit einer relativ hohen Frequenz. Dementsprechend schnell wird auch der Zähler betrieben, und als Folge davon wird das Stellsignal, welches dem Steueranschluß des Stellelements zugeführt wird, derart geformt, daß eine rasche Annäherung des Istsignals an das Sollsignal stattfindet.

Zweckmäßigerweise wird in einer bevorzugten Ausführungsform der Erfindung eine Vergleicherschaltung verwendet, die das Sollsignal mit dem Istsignal vergleicht und an ihrem Ausgang das Abweichungssignal bildet. Anstelle einer separaten Vergleicherschaltung besteht auch die Möglichkeit, das Istsignal und das Sollsignal direkt an die beiden Eingänge des spannungsgesteuerten Oszillators zu legen. Das Abweichungssignal ist dann die Spannungsdifferenz zwischen Sollsignal und Istsignal. Wesentlicher Bestandteil der erfindungsgemäßen Schaltung ist der spannungsgesteuerte Oszillator in Verbindung mit einem Zähler. Wie aus dem Zählerstand das Stellsignal gebildet wird, hängt vom speziellen Anwendungsfall ab. Denkbar ist zum Beispiel die Verwendung eines Analog-Stellsignals, welches auf den Steueranschluß (Basis, Gate) eines Transistors gegeben wird. Dieses Analog-Stellsignal könnte durch Digital-Analogwandlung aus dem Zählerstand des Zählers gewonnen werden, wobei der Zähler dann zweckmäßigerweise als Auf/Ab-Zähler (Vorwärts-Rückwärts-Zähler) ausgebildet ist. Je nach Vorzeichenlage des Differenzsignals, welches aus dem Subtrahieren des Istsignals von dem Sollsignal gewonnen wird, wird der Zählerstand erhöht oder erniedrigt, wobei die Geschwindigkeit des Zählens erfindungsgemäß von der Frequenz des Taktsignals am Ausgang des spannungsgesteuerten Oszillators abhängt.

In einer bevorzugten Ausgestaltung der Erfindung ist vorgesehen, daß das Stellsignal ein PWM-Stellsignal ist. Zu diesem Zweck ist vorzugsweise ein Digitalvergleicher vorgesehen, der mit einem ersten und einem zweiten Eingang sowie mit einem Ausgang ausgestattet ist, wobei der erste Eingang mit dem Ausgang des Zählers verbunden ist, der zweite Eingang mit einem Referenzwertgeber verbunden ist, und der Ausgang des Digitalvergleichers mit dem Steuereingang des Stellelements verbunden ist.

Abhängig von dem Verhältnis des Inhalts des Zählers zu dem Ausgangssignal des Referenzwertgebers wird das PWM-Stellsignal mit einem mehr oder weniger großen Tastverhältnis (Verhältnis der Impulsdauer zu der Impulspause) erzeugt.

In einer besonders bevorzugten Ausführungsform sieht die Erfindung vor, daß zwischen dem spannungsgesteuerten Oszillator und dem Zähltakteingang des Zählers ein Impulsformer geschaltet ist. Mit einem solchen Impulsformer können die Flanken des Tatksignals verbessert werden, da der spannungsgesteuerte Oszillator (VCO) in der Regel ein etwa sinusförmiges Signal liefert.

In einer Weiterbildung der Erfindung ist vorgesehen, daß zwischen den Ausgang des Digitalvergleichers und den Steueranschluß des Stellelements ein Monoflop geschaltet ist, und daß der Ausgang des Digitalvergleichers oder des Monoflops mit einem Rücksetzeingang des Zählers verbunden ist.

Bei einer solchen Schaltung ist die Impulsdauer des PWM-Signals stets unverändert groß, geändert wird nur die Länge der Impulspause zwischen den einzelnen Impulsen, und damit ändert sich die Frequenz des PWM-Stellsignals. Bei großer Regelabweichung zwischen Istsignal und Sollsignal wird der Zählerstand relativ schnell verändert aufgrund der hohen Frequenz des von dem VCO gelieferten Signals. Dementsprechend schnell erfolgt auch das Rücksetzen des Zählers. Da bei jedem Rücksetzvorgang des Zählers von dem Monoflop ein Impuls geliefert wird, wird das Tastverhältnis des PWM-Stellsignals größer. Hierdurch wird eine rasche Annäherung des Istsignals an das Sollsignal erreicht.

Der oben angesprochene wesentliche Bestandteil der erfindungsgemäßen Schaltung, also der spannungsgesteuerte Oszillator in Verbindung mit einem Zähler, wird erfindungsgemäß in einem speziellen Aspekt für einen digitalen Integrator genutzt.

Aus dem Stand der Technik sind zahlreiche Ausführungsformen von Integratoren bekannt. Ein analog arbeitender Integrator enthält zum Beispiel einen Operationsverstärker mit einem Kondensator im Rückkopplungszweig. Ein digitaler Integrator enthält einen Analog/Digital-Umsetzer, der das zu integrierende Analogsignal in digitale Werte umsetzt und dann das digitale Signal über die Zeit aufsummiert. Erfindungsgemäß wird von der oben angesprochenen Kombination aus spannungsgesteuertem Oszillator und Zähler Gebrauch gemacht. Hierzu schafft die Erfindung einen digitalen Integrator zum Integrieren eines Analogsignals, der folgende Merkmale aufweist:
- einen Eingang, dem das Analogsignal zugeführt wird,
- einen spannungsgesteuerten Oszillator, der das Analogsignal empfängt und ein Schwingungssignal erzeugt, dessen Frequenz von der Amplitude des Analogsignals abhängt, und
- einen Zähler, der das Schwingungssignal von dem spannungsgesteuerten Oszillator empfängt und an seinem Ausgang ein digitales Signal abgibt, das repräsentativ ist für das integrierte Analogsignal.

Bei diesem digitalen Integrator kann ein separater Analog/Digital-Wandler entfallen. Da die Frequenz des Ausgangssignals des VCO proportional zu der Amplitude der Eingangsspannung des VCO ist, zählt der an den Ausgang des VCO angeschlossene Zähler proportional schnell zu der Amplitude des Analogsignals. Am Ausgang des Zählers erhält man also das dem Integral des Analogsignals entsprechende digitale Signal.

In einer speziellen Ausführungsform ist der Zähler ein Auf/Ab-Zähler, der an einem Zählrichtungs-Eingang ein Vorzeichensignal empfängt, welches von dem vorzeichenbehafteten Analogsignal abgeleitet wurde.

Im folgenden werden Ausführungsbeispiele der Erfindung anhand der Zeichnungen näher erläutert. Es zeigen:
- Fig. 1: eine Schaltungsskizze einer elektrischen Schaltung zum Regeln einer induktiven Last gemäß einer ersten Ausführungsform der Erfindung;
- Fig. 2: ein Blockschaltbild eines Teils der Schaltung der ersten Ausführungsform der Erfindung gemäß Fig. 1;
- Fig. 3: ein Blockdiagramm einer zweiten Ausführungsform der erfindungsgemäßen Schaltung;
- Fig. 4: ein Impulsdiagramm zur Veranschaulichung des Regelverhaltens der Schaltungsvorrichtung nach Fig. 3;
- Fig. 5: ein Blockschaltbild einer dritten Ausführungsform der Erfindung;
- Fig. 6: ein Blockschaltbild einer vierten Ausführungsform der Erfindung, und
- Fig. 7: ein Blockschaltbild einer fünften Ausführungsform der Erfindung in Form eines Integrators.

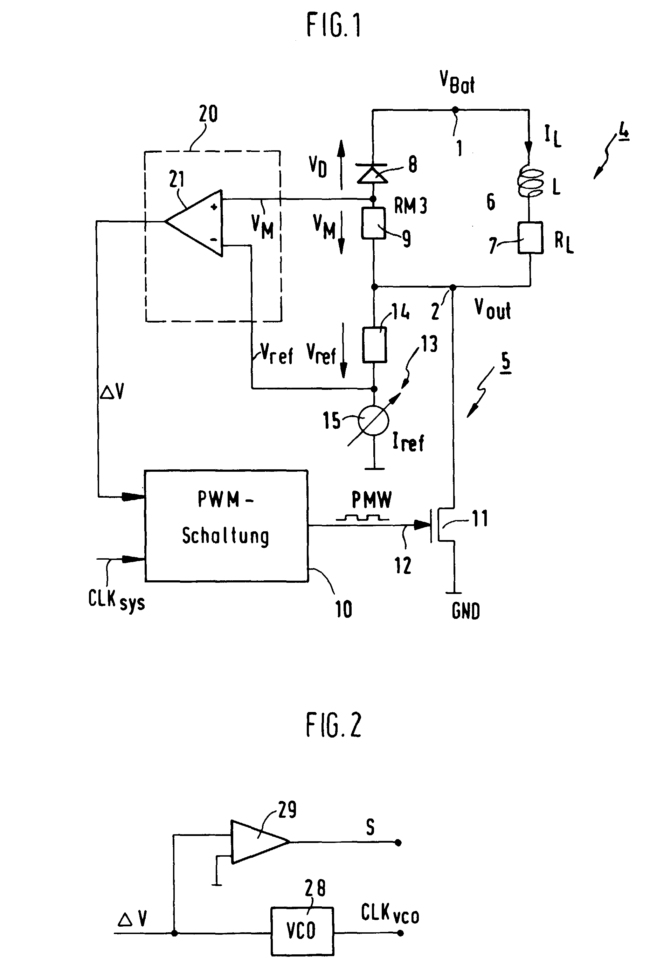

Fig. 1 und 2 zeigen eine erste Ausführungsform der erfindungsgemäßen Schaltung zum Steuern einer Last. Die im rechten Teil der Fig. 1 dargestellte Schaltung enthält einen ersten Schaltungszweig 4 mit einer zu regelnden induktiven Last 6 und einem dazugehörigen ohmschen Widerstand 7, einen zweiten Schaltungszweig 3 mit einer Freilaufdiode 8 und einem Meßwiderstand 9 (RM3), und einen dritten Schaltungszweig 5 mit einem elektronischen Schaltelement 11. Das Schaltelement 11 ist hier zum Beispiel ein MOSFET mit einem Steueranschluß 12.

Die Schaltungszweige 4 und 3 liegen zueinander parallel zwischen einem ersten Anschluß 1 (V_{Bat}) und einem zweiten Anschluß 2 (Vₒᵤₜ), der dritte Schaltungszweig 5 liegt zwischen dem zweiten Anschluß 2 und einem dritten Anschluß GND (Masse).

Zum Regeln des Stroms in der induktiven Last, die die Induktivität 6 mit dem Wert L und eine ohmsche Widerstandskomponente mit dem Wert R_{L} enthält, wird der Stromfluß durch die Last nach Maßgabe eines PWM-Stellsignals am Steueranschluß 12 des Stromschalters 11 ein- und ausgeschaltet. Beim Ausschalten des Stromschalters 11 wird der Stromfluß durch den dritten Schaltungszweig 5 gesperrt. Aufgrund der in der Induktivität gespeicherten Energie fließt nun der Strom I_{L} durch den zweiten Schaltungskreis 3, weil und solange die Schaltung an dem zweiten Anschluß 2, also Vₒᵤₜ, höher ist als die Spannung V_{Bat} (hierbei ist die Durchlaßspannung der Freilaufdiode 8 unberücksichtigt). Der Freilaufstrom durch die dann geöffnete Freilaufdiode 8 fließt auch durch den Meßwiderstand 9 oder RM3 und führt zu einer Meßspannung V_{M}.

An den zweiten Anschluß 2 ist ein vierter Schaltungszweig 13 angeschlossen, der eine veränderliche Stromquelle 15 und einen Referenzwiderstand 14 enthält. Die Stromquelle 15 liefert einen einstellbaren Referenzstrom Iref, der an dem Referenzwiderstand 14 zu einer Spannung Vref führt. Die Meßspannung V_{M} und die Referenzspannung Vref werden einem Vergleicher 20 zugeführt, der hier einen Differenzverstärker 21 enthält, und zwar wird die Meßspannung V_{M} dem nicht-invertierenden Eingang zugeführt, während die Referenzspannung Vref dem invertierenden Eingang zugeführt wird.

Gemäß Fig. 2 wird aus dem Ausgangssignal ΔV des Vergleichers von einem OP- Verstärker 29 ein Vorzeichensignal S mit entweder hohem oder niedrigem Pegel gebildet. Der Pegel gibt an, ob das Signal V_{M} größer als Vref ist, oder umgekehrt. Das Vorzeichensignal S wird in einer PWM-Schaltung 10 gebildet, die außerdem mit einem spannungsgesteuerten Oszillator (VCO) 28 ein Eingangs-Taktsignal CLK_{VCO} erzeugt. Das Taktsignal CLK_{VCO} bestimmt das Tastverhältnis des PWM-Stellsignals am Ausgang der PWM-Schaltung 10, welches dem Steueranschluß 12 des Stromschalters 11 zugeführt wird.

Im folgenden wird die Arbeitsweise der Schaltung nach den Fig. 1 und 2 näher erläutert.

Ein Taktsignal CLK_{sys} am Eingang der PWM-Schaltung 10 besitzt eine feste Periodendauer, die die Periodendauer des PWM-Stellsignals am Anschluß 12 des Stromschalters 11 festlegt.

Während das Stromschaltelement 11 gesperrt ist und der Strom I_{L} durch den zweiten Schaltungszweig 3 fließt, nimmt dieser Strom I_{L} und mithin die Meßspannung V_{M} allmählich ab. Wenn der Wert der Meßspannung V_{M} den Wert der Referenzspannung Vref erreicht, ändern sich die Vorzeichenverhältnisse an den beiden Eingängen des Vergleichers 20, so daß sich folglich der Pegel des am Ausgang des Vergleichers erscheinenden Abweichungssignals ΔV ändert. Durch diese Pegeländerung wird das PWM-Stellsignal geändert, wodurch das Stromschaltelement 11 geöffnet wird. Hierdurch sinkt die Spannung Vout am zweiten Anschluß 2 schlagartig auf Null (genauer gesagt: auf annähernd Null, wenn man den Einschaltwiderstand Ron des Stromschaltelements 11 berücksichtigt).

Während das Stromschaltelement geöffnet ist, fließt der Strom durch den ersten Schaltungszweig 4, wobei sich die Stromstärke allmählich erhöht. Bei zu großem Strom in der induktiven Last 6 wird aufgrund der dann höheren Meßspannung V_{M} eine längere Zeitspanne benötigt wird, bis die Spannung V_{M} auf den Wert von Vref abgesunken ist.

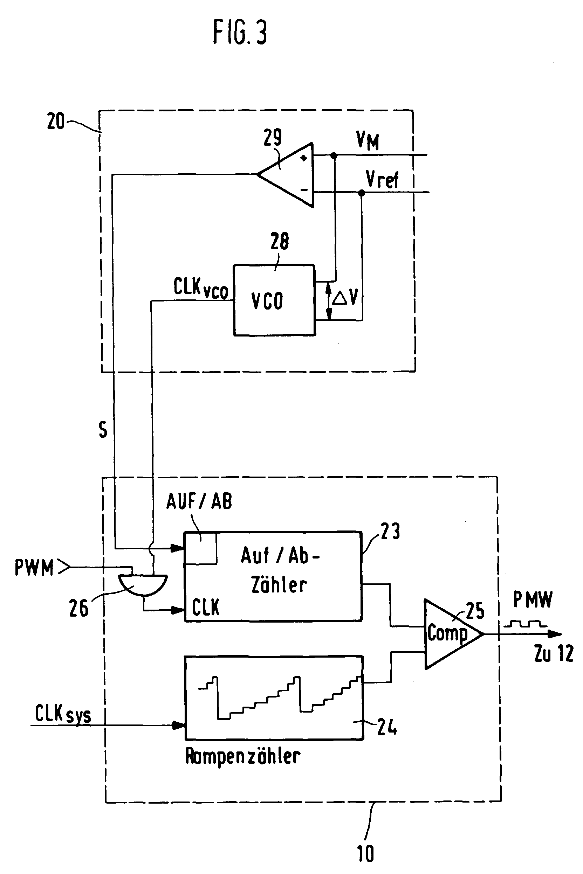

Fig. 3 zeigt eine zweite Ausführungsform der erfindungsgemäßen Schaltung. Bei dieser Ausführungsform enthält die PWM-Schaltung 10 einen Auf/Ab-Zähler 23 mit einem Aufwärts/Abwärts-Setzeingang, dem das Vorzeichensignal S von dem Vergleicher 20 zugeführt wird, einem Takteingang und einem Ausgang, der mit einem Eingang eines Digitalvergleichers (Comp) 25 verbunden ist, ferner einen Rampenzähler 24, der mit einem zweiten Eingang des Digitalvergleichers 25 verbunden ist und ein UND-Gatter 26.

Die in Fig. 3 dargestellten Schaltungskomponenten sind an sich bekannte Bauteile, deren Funktionsweise dem Fachmann bekannt ist. Das Eingangssignal CLK_{sys} wird dem Takteingang des Rampenzählers zugeführt, so daß der Rampenzähler relativ schnell von Null bis auf seinen Maximalwert hochzählt und dabei an dem Ausgang ein digitales Rampensignal erzeugt. Nach Ablauf einer von der Taktfrequenz und der Stellenzahl des Zählers abhängigen Periodendauer fängt der Zähler wieder bei Null an, erneut hochzuzählen. Das Taktsignal CLK_{VCO} wird auf den Takteingang des Auf/Ab-Zählers 23 gegeben. Das UND-Gatter 26 wird von dem invertierten PWM-Stellsignal geöffnet.

Der Zählerstand des Auf/Ab-Zählers 23 ändert sich abhängig von der Änderung des Vorzeichensignals S langsam nach oben oder nach unten. Besteht Gleichheit zwischen dem Ausgangssignal des Auf/Ab-Zählers 23 und dem sich demgegenüber rasch ändernden Rampensignal am Ausgang des Rampenzählers 24, erfolgt ein Umschalten des Pegels am Ausgang des Digitalvergleichers 25, wodurch das PWM-Stellsignal für den Steueranschluß 12 des Stromschaltelements 14 gebildet wird.

Dem Rampenzähler 24 der PWM-Schaltung 10 nach Fig. 3 wird ein Systemtaktsignal CLKsys zugeführt, welches eine konstante Frequenz von zum Beispiel 4 kHz hat.

Dem Auf/Ab-Zähler 23 der PWM-Schaltung 10 wird das Taktsignal veränderlicher Frequenz CLK_{VCO} zugeführt. Hierzu ist in dem Vergleicher 20 gemäß Fig. 3 außer dem OP-Verstärker 29, der das Vorzeichensignal S liefert, noch ein spannungsgesteuerter Oszillator (VCO) 28 enthalten (der bei der Ausführungsform nach Fig. 1 und 2 in der PWM-Schaltung 10 enthalten ist), der als Eingangsspannung die Differenzspannung aus der Meßspannung V_{M} und der Referenzspannung Vref empfängt und abhängig von dieser Differenzspannung ein Ausgangs-Schwingungssignal oder Ausgangs-Impulssignal veränderlicher Frequenz erzeugt. Bei starkem Unterschied zwischen V_{M} und Vref ist die Frequenz des Ausgangssignals CLK_{VCO} des VCO 28 relativ hoch, so daß dementsprechend - bei geöffnetem UND-Gatter 26 - der Auf/Ab-Zähler 23 relativ schnell zählt (abhängig vom Vorzeichensignal S nach oben oder nach unten). Bei Annäherung der beiden Spannungen V_{M} und Vref wird die Frequenz des Taktsignals CLK_{VCO} am Ausgang des VCO 28 geringer, so daß dementsprechend der Auf/Ab-Zähler 23 langsamer zählt. Dieser Ablauf bedeutet, daß bei einer starken Regelabweichung der Auf/Ab-Zähler sehr schnell zählt, also für eine rasche Annäherung des Ist-Stromwerts an den Soll-Stromwert gesorgt wird, daß aber bei geringer Regelabweichung entsprechend langsam nachgeregelt wird, wodurch Überschwinger vermieden werden oder gering gehalten werden.

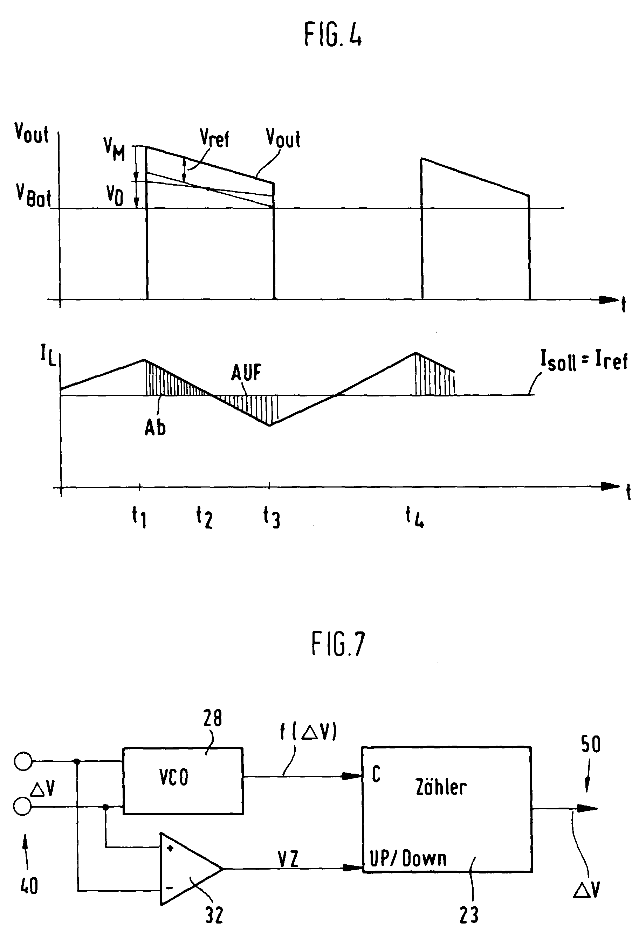

Um die Arbeitsweise der Schaltung der Ausführungsform nach Fig. 3 zu erläutern, sei auf Fig. 4 Bezug genommen. Die Spannung Vout ändert sich sprunghaft mit dem Öffnen und dem Schließen des Stromschalters 11. Der zu regelnde Strom I_{L} schwankt um den Soll-Strom, der dem Referenzstrom Iref entspricht. In dem Intervall zwischen den Zeitpunkten t1 und t2 erfolgt entsprechend dem Vorzeichensignal S ein Abwärtszählen. In dem dann anschließenden Intervall zwischen den Zeitpunkten t2 und t3 erfolgt ein Aufwärtszählen. Der Wechsel der Zählrichtung in dem Auf/Ab-Zähler 23 und hängt ab von dem Zeitpunkt, zu dem die Meßspannung V_{M} der Referenzspannung Vref gleicht. In der oberen Zeile in Fig. 4 ist zusätzlich noch die Durchlaßspannung der Diode, V_{D}, dargestellt.

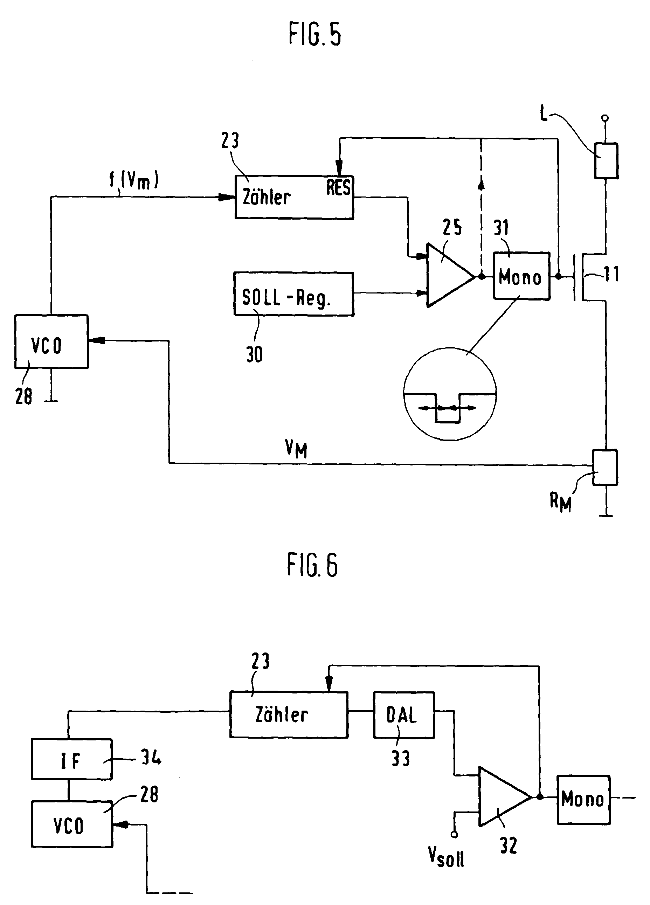

Fig. 5 zeigt eine dritte Ausführungsform der erfindungsgemäßen Schaltung zum Regeln einer Last. Wie bei den obigen Ausführungsbeispielen wird das Istsignal durch die Spannung Vm (Meßspannung) dargestellt. Das Sollsignal entspricht der Referenzspannung Vref. Die Spannung Vm wird an den VCO 28 gelegt, der abhängig von der Spannung ein Ausgangssignal mit einer Frequenz f (Vm) auf einen Zähler 23 gibt, dessen Ausgang an einen Eingang eines Digitalvergleichers 25 angeschlossen ist. Am anderen Eingang des Digitalvergleichers 25 liegt das Ausgangssignal eines Sollwert-Registers 30. Der Zähler 23 wird von dem Ausgangssignal des VCO 28 mit dem Taktsignal der Frequenz f (Vm) hochgezählt. Bei Übereinstimmung des Inhalts des Zählers 23 mit dem Inhalt des Registers 30 wechselt der Pegel des Ausgangssignals des Digitalvergleichers 25, und da der Ausgang des Digitalvergleichers 25 mit dem Rücksetzeingang (RES) des Zählers 23 verbunden ist, wird der Zähler 23 auf Null zurückgesetzt, um erneut mit dem Hochzählen zu beginnen. Durch den zurückgesetzten Inhalt des Zählers 23 wird auch das Ausgangssignal des Digitalvergleichers 25 wieder zurückgesetzt. Das Ausgangssignal des Digitalvergleichers 25 wird auf ein Monoflop 31 gegeben, welches ein PWM-Stellsignal liefert. Je größer die Spannung Vm am Eingang des VCO 28 ist, desto höher ist die Frequenz f (Vm), und desto schneller zählt der Zähler 23 hoch. Dementsprechend kurz ist auch nur das Intervall bis zum nächsten Wechsel des Ausgangssignals des Digitalvergleichers 25. Die Impulspausen des PWM-Stellsignals sind also relativ kurz, wenn die Spannung am Eingang des VCO 28 relativ hoch ist.

Anstatt den Zähler 23 mit dem Ausgangssignal des Digitalvergleichers 25 zurückzusetzen, kann hierzu auch das Ausgangssignal des Monoflops 31 verwendet werden.

Fig. 6 zeigt eine gegenüber der Ausführungsform nach Fig. 5 abgewandelte, vierte Ausführungsform der Erfindung. Anstelle des in Fig. 5 gezeigten Sollwert-Registers 30 wird eine zweite Referenzspannung Vₛₒₗₗ an einen Eingang eines Vergleichers 32 gegeben, der als Analogvergleicher ausgebildet ist. Dem anderen Eingang des Analogvergleichers 32 wird das Ausgangssignal eines Digital-Analog-Wandlers (DAC) 33 zugeführt, der den Zählerstand des Zählers 23 in ein Analogsignal umsetzt.

Zwischen dem VCO 28 und dem Zähler 23 ist ein Impulsformer 34 vorgesehen, der auch bei der Ausführungsform nach Fig. 5 zur Impulsformung des Ausgangssignals des VCO 28 vorgesehen sein kann. Im Gegensatz zu der Ausführungsform nach Fig. 5 erfolgt bei der vierten Ausführungsform nach Fig. 6 der Vergleich von zwei Analogwerten. Im übrigen arbeitet die Schaltung nach Fig. 6 genauso wie die Schaltung nach Fig. 5.

Eine weitere Ausführungsform der Erfindung ist in Fig. 7 dargestellt. Fig. 7 zeigt einen digitalen Integrator mit einem Eingang 40 und einem Ausgang 50. An den Eingang 40 wird ein Analogsignal ΔV gelegt, am Ausgang 50 wird ein digitales Signal entsprechend dem Integral des Analogsignals ΔV erzeugt. Auch diese Schaltung kann zum Steuern einer Last verwendet werden, allerdings ist die Erfindung nicht auf eine solche Verwendungsmöglichkeit beschränkt. Bei dem in Fig. 7 gezeigten digitalen Integrator bildet der spannungsgesteuerte Oszillator (VCO) 28 entsprechend der Amplitude des Eingangssignals ΔV ein Schwingungssignal f (ΔV), welches an den Zähleingang C des Auf/Ab-Zählers 23 gelegt wird. Außerdem erzeugt ein Vorzeichengeber 32 aus dem vorzeichenbehafteten Analogsignal ΔV ein Vorzeichensignal Vz, beispielsweise positiven Pegel für positives Vorzeichen des Analogsignal ΔV, und Null-Pegel für ein negatives Analogsignal. Das Signal Vz an dem Auf/Ab-Eingang des Zählers 23 legt die Zählrichtung des Zählers fest. Da die Frequenz f des Ausgangssignals des VCO 28 proportional zur Amplitude der Spannung ΔV ist, erhält man am Ausgang des Zählers 23 ein dem Zählerstand entsprechendes Signal, welches den Digitalwert des Integrals der Analogspannung ΔV repräsentiert.

## Patentansprüche

1. Elektrische Schaltung zum Steuern einer Last nach Maßgabe eines Sollsignals (Vref), umfassend:
- eine erste Signalquelle (14, 15), die das Sollsignal (Vref) ausgibt,
- eine zweite Signalquelle (9, RM3), die ein Istsignal (V_{M}) ausgibt, welches repräsentativ ist für den aktuellen Zustand der Last (6, 7);
- ein Stellelement (11), das mit der Last (6, 7) gekoppelt ist, und das einen Steueranschluß (12) aufweist,
- eine Stellsignal-Erzeugungsschaltung (10), die an einem Eingang ein Abweichungssignal (ΔV, S, CLK_{VCO}) empfängt, welches repräsentativ ist für die Differenz zwischen dem Sollsignal (Vref) und dem Istsignal (V_{M}), die abhängig von dem Abweichungssignal ein Stellsignal (PMW) erzeugt und das Stellsignal über einen Ausgang dem Steuereingang (12) des Stellelements (11) zuführt,
- wobei die Stellsignal-Erzeugungsschaltung (10) einen Zähler (23) beinhaltet, der in Abhängigkeit von dem Abweichungssignal (ΔV, S, CLK_{VCO}) betrieben wird, um das Stellsignal zu erzeugen, und wobei ein Zähltakteingang des Zählers (23) mit dem Ausgang eines spannungsgesteuerten Oszillators (28) verbunden ist, der an seinem Eingang das Abweichungssignal (ΔV) empfängt.

2. Schaltung nach Anspruch 1, dadurch gekennzeichnet, daß eine Vergleicherschaltung (20; 28) vorgesehen ist, die das Sollsignal mit dem Istsignal vergleicht und an ihrem Ausgang das Abweichungssignal bildet.

3. Schaltung nach Anspruch 1 oder 2, dadurch gekennzeichnet, daß das Stellsignal ein PWM-Stellsignal ist.

4. Schaltung nach Anspruch 3, dadurch gekennzeichnet, daß ein Digitalvergleicher (25) mit einem ersten und einem zweiten Eingang und einem Ausgang vorgesehen ist, wobei der erste Eingang mit dem Ausgang des Zählers (23) verbunden ist, der zweite Eingang mit einem Referenzwertgeber (24) verbunden ist, und der Ausgang mit dem Steuereingang (12) des Stellelements (11) verbunden ist.

5. Schaltung nach einem der Ansprüche 1 bis 4, dadurch gekennzeichnet, daß zwischen dem spannungsgesteuerten Oszillator und dem Zähltakteingang des Zählers (23) ein Impulsformer (34) geschaltet ist.

6. Schaltung nach Anspruch 4 oder 5, dadurch gekennzeichnet, daß zwischen den Ausgang des Digitalvergleichers (25) und den Steueranschluß (12) des Schaltelements (11) ein Monoflop (31) geschaltet ist, und daß der Ausgang des Digitalvergleichers oder des Monoflops mit einem Rücksetzeingang des Zählers (23) verbunden ist.

7. Digitaler Integrator zum Integrieren eines Analogsignals (ΔV), umfassend:
- einen Eingang (40), dem das Analogsignal (ΔV) zugeführt wird,
- einen spannungsgesteuerten Oszillator (VCO) (28), der das Analogsignal empfängt und ein Schwingungssignal erzeugt, dessen Frequenz (f) von der Amplitude des Analogsignals abhängt, und
- einen Zähler (23), der das Schwingungssignal von dem spannungsgesteuerten Oszillator (VCO) (28) empfängt und an seinem Ausgang ein digitales Signal abgibt, das repräsentativ ist für das integrierte Analogsignal.

8. Digitaler Integrator nach Anspruch 7, dadurch gekennzeichnet, daß ein Vorzeichengeber (32) von dem Eingang (40) das polaritätsbehaftete Analogsignal (ΔV) empfängt und ein Vorzeichensignal (VZ) erzeugt, und daß der Zähler (23) ein Auf/Ab-Zähler ist, der das Vorzeichensignal (VZ) empfängt und abhängig von dem Vorzeichensignal aufwärts bzw. abwärts zählt.
